# EUROPEAN PATENT SPECIFICATION

(11) **EP 0 472 357 B1**
(45) Date of publication and mention of the grant of the patent: **26.07.1995**
(21) Application number: 91307502.4
(22) Date of filing: 14.08.1991
(51) Int. Cl.: H01L 27/06, H01L 27/02, H01L 23/48

(54) **A semiconductor integrated circuit**
Integrierter Halbleiterschaltkreis
Circuit intégré à semi-conducteur

(30) Priority: 22.08.1990 JP 223687/90
(43) Date of publication of application: 26.02.1992
(73) Proprietor: MITSUBISHI DENKI KABUSHIKI KAISHA, Tokyo (JP)
(72) Inventor: Tanino, Noriyuki, c/o Mitsubishi Denki K.K., Itami-shi, Hyogo-ken (JP)
(74) Representative: Beresford, Keith Denis Lewis

(56) References cited:
- EP-A- 0 098 167
- EP-A- 0 316 799
- PATENT ABSTRACTS OF JAPAN vol. 10, no. 184 (E-415)27 June 1986
- PATENT ABSTRACTS OF JAPAN vol. 13, no. 401 (E-816)6 September 1989
- PATENT ABSTRACTS OF JAPAN vol. 14, no. 225 (E-927)14 May 1990

## Description

### FIELD OF THE INVENTION

The present invention relates to a semiconductor integrated circuit for processing a high frequency signal such as microwave signal, and more particularly to a structure of a microwave monolithic integrated circuit for preventing electrostatic breakdown in the fabricating process thereof.

### BACKGROUND OF THE INVENTION

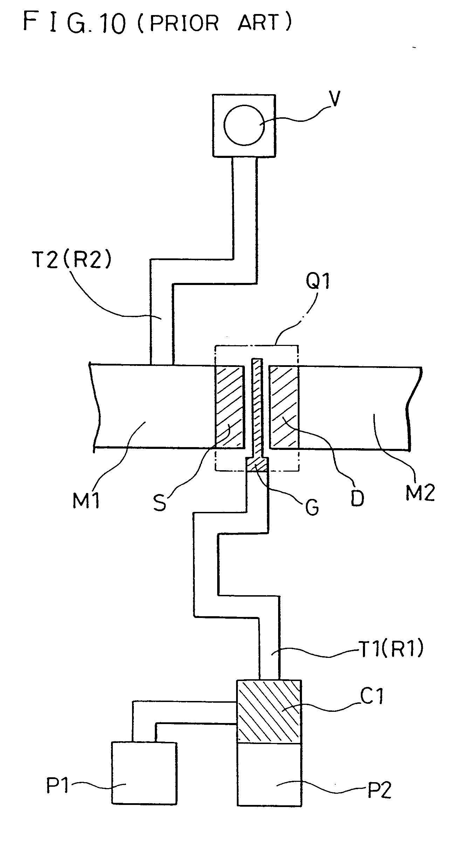

Figure 10 is a plan view showing a semiconductor integrated circuit of a high frequency switch as an example of a semiconductor integrated circuit utilizing a dielectric substrate in accordance with a prior art. In figure 10, reference character Q₁ designates a field effect transistor (hereinafter referred to as 'FET') constructed on a dielectric substrate 1, which has a source S, a gate G, and a drain D. A first transmission line T₁ is connected to the gate G of the FET Q₁ and the electric length thereof is usually established at one fourth wavelength of the microwave signal, which enables impedance matching of the first transmission line T₁ with the gate G. A capacitor C₁ is connected to the first transmission line T1 and this is also connected to the grounding bonding pad P₂. A gate bias bonding pad P₁ is provided in contact with the node of the first transmission line T₁ and the first capacitor C₁. A second transmission line T₂ is connected to the source S of the FET Q₁. A via-hole V is provided for connecting the second transmission line T₂ with a rear surface electrode 4 produced at the rear surface of the dielectric substrate 1. Reference characters M₁ and M₂ designate transmission lines connected to the source S and the drain D of the FET Q₁, respectively.

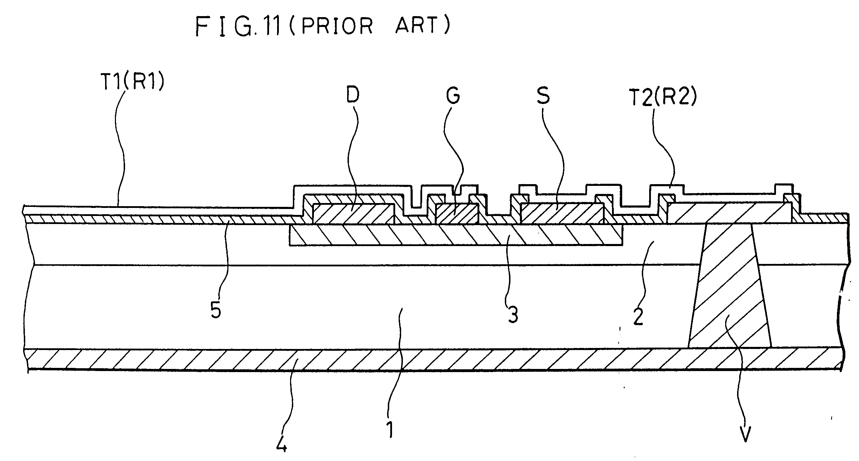

Figure 11 is a cross sectional view showing the device of figure 10 and schematically shows the FET portion, the via-hole portion, and the connecting relation between these and the transmission lines T₁ and T₂. Figure 11 does not completely coincide with a plane pattern of figure 10. In figure 11, reference numeral 2 designates a semiconductor layer such as GaAs produced on a dielectric substrate 1 by such as epitaxial growth method. An operating layer 3 of the FET Q₁ is produced in the semiconductor layer 2 by implanting n conductivity type impurities such as silicon using such as ion implantation method. A source electrode S and a drain electrode D are produced on the operating layer 3 and a gate electrode G is produced on the operating layer 3 between the both electrodes. Here, an insulating substrate comprising such as sapphire or alumina is used for the dielectric substrate 1, gold-germanium alloy is used for the source S and the drain D which are in ohmic contact with the operating layer 3, and aluminum is used for the gate electrode G which is in Schottky contact with the operating layer 3. The transmission lines M₁, M₂, T₁, and T₂ comprise metal material. Reference numeral 5 designates an insulating film on which the transmission lines T₁ and T₂ are produced. The other same reference numerals as those shown in figure 10 designate the same parts.

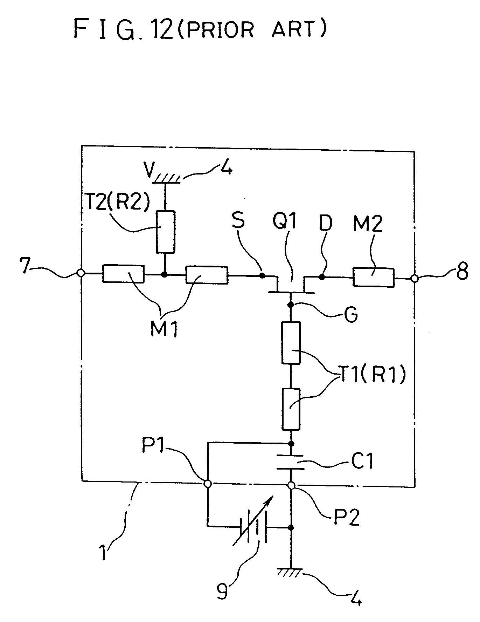

Figure 12 shows an equivalent circuit of the above-described semiconductor integrated circuit. An RF input terminal 7 and an RF output terminal 8 are connected to the transmission lines M₁ and M₂, respectively. A gate bias voltage power supply 9 is corrected to the gate bias bonding pad P₁. The other same reference numerals as those shown in figures 10 and 11 designate the same portions.

The operation will be described with reference to the equivalent circuit shown in figure 12.

A high frequency signal such as microwave signal is input to the RF input terminal 7, supplied to the FET Q₁ through the transmission line M₁, and output from the RF output terminal 8 through the transmission line M₂.

The transmission line T₁ and the capacitor C₁ form a gate bias circuit of the FET Q₁, and in this example a voltage bias is applied to the gate G of the FET from the gate bias power supply 9 which is provided outside the dielectric substrate 1, through the gate bias bonding pad P₁. Here, the electrical length of the transmission line T₁ is usually established at one fourth wavelength of the microwave signal and the end terminal of the transmission line T₁ is grounded at a high frequency via the capacitor C₁. Therefore, viewed at the gate of the FET Q₁, the impedance of the transmission line T₁ becomes infinite, which prevents the microwave signal from leaking to the gate G of the FET through the gate-source or the gate-drain capacitance of the FET Q₁.

A resistor R₁ can be used instead of the transmission line T₁. In such case the value of the resistor R₁, typically 1 KΩ which is sufficiently higher than characteristics impedance of the-transmission line M₁, typically 50Ω , enables preventing the microwave signal from leaking to the gate G of the FET through the gate-source or gate-drain capacitance of the FET Q₁. Here, the resistor R₁ can be made of a semiconductor layer or a thin film resistor.

The capacitor C₁ also prevents unrequired high frequency signal from being applied to the gate of the FET Q₁ from outside of the dielectric substrate 1 through the gate bonding pad P₁. Here, in the device of figure 12, although the capacitor C₁ is grounded at the rear surface electrode via the grounding bonding pad P₂, it can be grounded inside the dielectric substrate 1 using a via-hole.

The transmission line T₂ produces a source voltage bias circuit of the FET Q₁, and in this example, the source voltage bias circuit of the FET Q₁ is grounded at the rear surface electrode 4. The electrical length of the transmission line T₂ is established at one fourth wavelength of the microwave signal. Thus, similarly as in the case of the gate bias circuit, the microwave signal is prevented from leaking to the transmission line T₂ from the transmission line M₁. Here, when a second resistor R₂ is used in place of the transmission line T₂, establishing the value of the resistor R₂ at a value, typically 1 k Ω , sufficiently higher than the characteristic impedance of the transmission line M₁, typically 50Ω , enables preventing the leakage of the microwave signal.

In the semiconductor integrated circuit as described above, the attenuation quantity of the intensity of the microwave signal input from the RF input terminal 7 is controlled by varying the gate bias voltage of the FET Q₁, more concretely by varying the drain-source resistance of the FET Q₁ in a range from a sufficiently small value of several Ω to a sufficiently large value of several M Ω , thereby enabling taking out a signal from the RF output terminal 8.

In the above-described prior art example, an electrical length of the transmission line T₂ is established at one fourth wavelength, but a microwave switching circuit which can make the microwave signal input from the RF output terminal 8 grounded or opened at the FET Q₁ can be obtained by directly grounding the source S of the FET Q₁ with the transmission line T₂ and the transmission line M1 dispensed with.

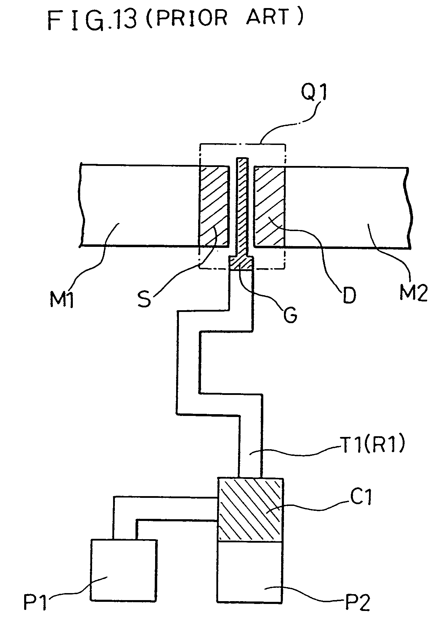

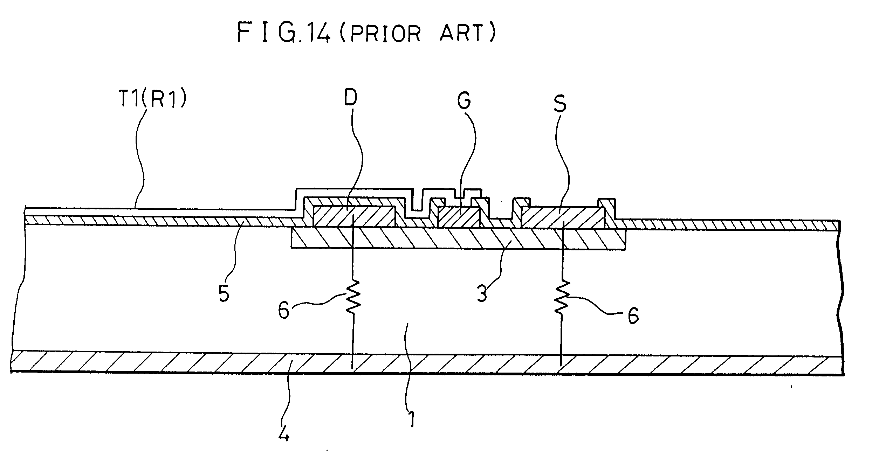

Figure 13 is a plan view showing a semiconductor integrated circuit constituting a high frequency switch which is a prior art example of a semiconductor integrated circuit using a semi-insulating semiconductor substrate. Figure 14 is a cross sectional view thereof and this schematically shows the FET portion, the via-hole portion, and the connecting relation between these and the transmission lines T₁ and T₂. In figure 13, the same reference numerals as those shown in figures 10 and 11 designate the same portions. A semi-insulating semiconductor substrate 14 is used in place of the dielectric substrate in the semiconductor integrated circuit shown in figures 10 to 12 and the source S and the drain D of the FET Q₁ are connected to the rear surface electrode 4 via the substrate resistor 6. Here, because the bias circuit of the source S is provided at the outside, the second transmission line T₂ and the via-hole V are not used for connecting the source S to the rear surface electrode.

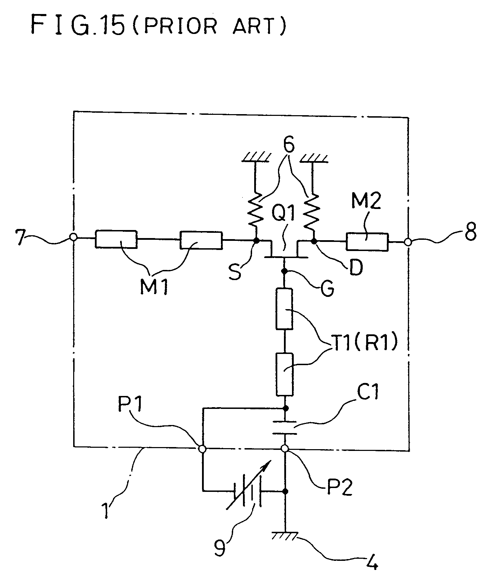

Figure 15 shows an equivalent circuit of the semiconductor integrated circuit of figure 13. In figure 15, reference numeral 6 designates a substrate resistor between the source S, drain D and the rear surface electrode 4. The same reference numerals as those shown in figure 12 designate the same portions.

The operation of the circuit of figure 13 will be described with reference to the equivalent circuit of figure 15.

In the equivalent circuit of figure 15, since there is no transmission line T₂ and no via-hole V shown in figure 12, a source bias is applied from outside of the semi-insulating semiconductor substrate 1 using a circuit construction for applying DC bias such as biastee. In a case of using a semi-insulating semiconductor substrate 1, a substrate resistor 6 exists between the rear surface electrode 4 and the source S or the drain D of the FET as shown in figure 14, differently from the case of using a semi-insulating dielectric substrate such as sapphire substrate, and the value of this substrate resistor 6 is usually more than 1 MΩ. Therefore, the circuit operation is similar as that of the equivalent circuit of figure 12.

The prior art semiconductor integrated circuit which has a construction as described above, where the gate of the FET Q₁ is insulated from the source or the drain of the FET Q₁ from a view point of DC, has a following problem. That is, in a process of fabricating a semiconductor integrated circuit such as a chip separation process, pure water which is blown to a wafer while cutting a semiconductor integrated circuit substrate by a dicing-saw causes the electrification of the gate bias circuit, that is, the electrification of the bonding pads for the gate, the source, and the drain which are not covered with passivation films, and this results an electrostatic breakdown of a gate.

In Japanese Patent Laid-Open Publication No. Sho. 60-47469 is recited a Schottky gate field effect transistor in which a pn junction element having a serial resistance lower than that of the gate electrode is connected in parallel between the gate electrode and the source or drain electrode, whereby the gate electrode is protected from an impulse voltage applied from the outside.

However, since the resistance of the pn junction element is smaller than the serial resistance of the gate, the impedance at the gate changes and the impedance matching is not performed in the microwave circuit. As a result, a leakage or reflection of the transmitting microwave arises exerting unfavorable influence on the input side circuit.

In the Japanese Patent Laid-Open Publication No. Sho. 61-30078 is recited a microwave band high output transistor in which the gate electrode and the grounding electrode are connected to each other by a diffusion region produced directly below the gate pad and thus avoidance of the gate destruction is attempted. However, even in this construction the resistance value of the diffusion region is only about 200 Ω, and there also arises a problem of impedance mismatching.

### SUMMARY OF THE INVENTION

The present invention is directed to solving the above described problems and has for its object to provide a microwave monolithic integrated circuit that prevents the electrification of the gate bias circuit without arising impedance mismatching at the gate, and the destruction caused by the electrification of the gate of the FET in the gate fabrication process of a field effect transistor is prevented.

Other objects and advantages of the present invention will become apparent from the claims.

In accordance with an aspect of the present invention, static electricity charged to the gate bias bonding pad or the capacitor constituting the gate bias circuit in the fabrication process flows not through the gate of the FET but through the auxiliary current path, whereby the gate-can be protected from the electrostatic breakdown.

### BRIEF DESCRIPTION OF THE DRAWINGS

Figure 1 is a plan view showing a semiconductor integrated circuit in accordance with a first embodiment of the present invention;
Figure 2 is a diagram schematically showing the cross sectional structure thereof;
Figure 3 is a diagram showing an equivalent circuit thereof;
Figure 4 is a plan view showing a semiconductor integrated circuit in accordance with a second embodiment of the present invention;
Figure 5 is-a diagram schematically showing a cross sectional structure thereof;
Figure 6 is a diagram showing an equivalent circuit thereof;
Figure 7 is a plan view showing a semiconductor integrated circuit in accordance with a third embodiment of the present invention;
Figure 8 is a diagram schematically showing a cross sectional structure thereof;
Figure 9 is a diagram showing an equivalent circuit thereof;
Figure 10 is a plan view showing a high frequency switch semiconductor integrated circuit as an example of a prior art semiconductor integrated circuit using a dielectric substrate;
Figure 11 is a diagram schematically showing a cross sectional structure thereof;
Figure 12 is a diagram showing an equivalent circuit thereof;
Figure 13 is a plan view showing a high frequency switch semiconductor integrated circuit as an example of a prior art semiconductor integrated circuit using a semi-insulating semiconductor substrate;
Figure 14 is a diagram schematically showing a cross sectional structure thereof; and
Figure 15 is a diagram showing an equivalent circuit thereof.

### DETAILED DESCRIPTION OF THE PREFERRED EMBODIMENT

An embodiment of the present invention will be described in detail with reference to the drawings.

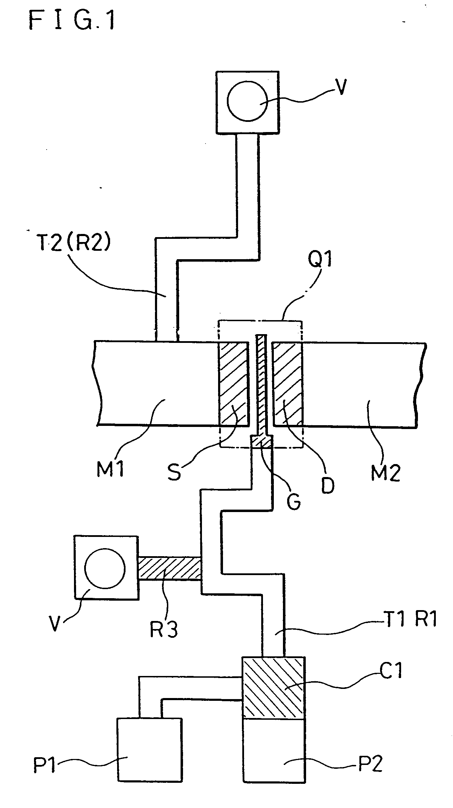

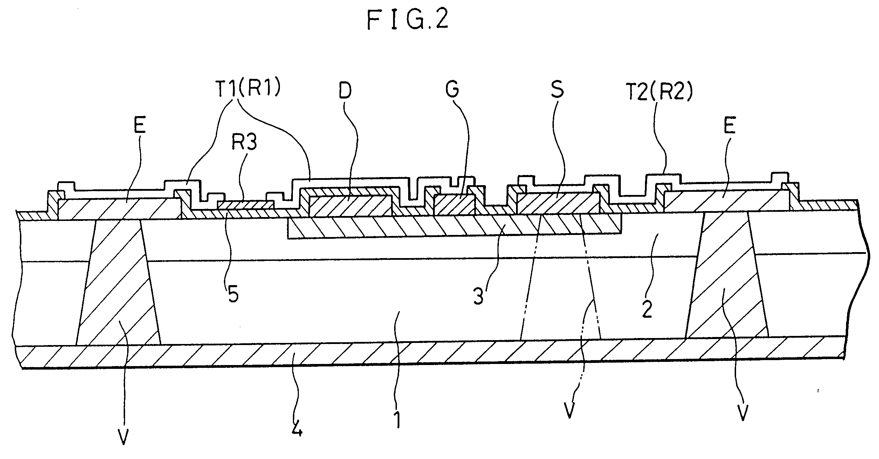

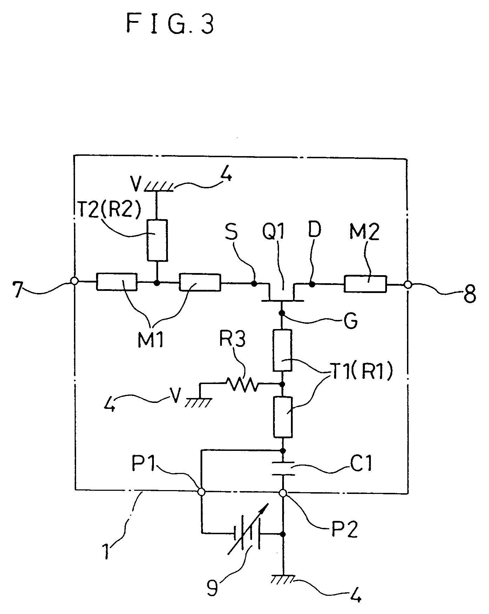

Figure 1 shows a high frequency switch semiconductor integrated circuit as an example of semiconductor integrated circuit using a dielectric substrate in accordance with a first embodiment of the present invention. Figure 2 is a cross sectional view thereof showing the FET portion, the via-hole portion, and the connecting relation between these and the transmission lines T₁ and T₂. Figure 3 shows an equivalent circuit thereof. These figures 1 to 3 correspond to figures 10 to 12 which show a prior art example and the same reference numerals designate the same or corresponding portions. In this first embodiment of the invention, the first transmission line T₁ is connected to the rear surface electrode via the third resistor R₃ of about 100 KΩ . This resistor R₃ has a sufficiently high resistance value,as described above and affects almost no influence on the gate bias circuit.

In other word, a via-hole V₁ is produced in the vicinity of the transmission line T₁. A third resistor R₃ comprising a refractory metal silicide layer such as nichrome (alloy of nickel and chrome), tungsten silicide, or molybdenum silicide, is produced on an insulating film 5 between the via-hole V and the transmission line T₁. This resistor R₃ is connected to the transmission line T1 at its one end and to the rear surface electrode 4 through the via-hole V at its other end.

The fabrication process will be described.

First of all, a GaAs semiconductor layer 2 is epitaxially grown on a wafer substrate 1 comprising such as sapphire, and subsequently n conductivity type impurity such as silicon is ion implanted into the GaAs semiconductor layer 2 to produce an operating layer 3 at a surface region of the semiconductor layer 2.

Next, a gold-germanium alloy layer is patterned on the operating layer 3 and a source S and a drain D are produced from the gold-germanium alloy layer. Thereafter, an aluminum layer is patterned to produce a gate G. Then, an electrode layer E comprising gold is produced at a position corresponding to the via-hole which is produced in the later process.

Next, an insulating film 5 is patterned on the entire surface, a third resistor layer R₃ comprising the above described refractory metal silicide layer is patterned, and then a first and a second transmission lines T₁ and T₂, transmission lines M₁ and M₂, and gate bonding pads P₁ and P₂ all comprising metal material are produced. At this time, the capacitor C₁ is also produced and portions other than the bonding pad portion are covered by a passivation film.

Thereafter, the sapphire substrate 1 is etched back from the rear surface side to a predetermined thickness, a via-hole V is produced by etching, and further the entire surface is gilded by gold so as to bury the via-hole and produce a rear surface electrode 4.

Then, the wafer substrate is separated into chips by a dicing-saw.

The function and effect of this embodiment will be described.

Although the semiconductor integrated circuit is devised so as to be able to suppress generation of static electricity in the fabrication process, there are some cases where sufficient countermeasure cannot be implemented. In a case where chip separation with a dicing-saw is implemented, it is necessary to spray pure water to the dielectric substrate at a high pressure in order to wash out the dust generated by cutting. However, because the pure water has high resistance and is likely to be charged, electrode portions such as an exposed bonding pad produced on the dielectric substrate is easily electrified by charges conveyed by the pure water.

In such case, in the semiconductor integrated circuit of this embodiment, since the gate G of the FET Q₁ is grounded at the rear surface electrode 4 via the third resistor R₃, charges conveyed by the pure water flow to the rear surface electrode 4 through the third resistor R₃ and the gate G should not have a high voltage due to electrification. On the other hand, because the source S of the FET Q₁ is connected to the rear surface electrode 4 through the via-hole V, the source S does not have a high voltage due to electrification, either. Further, although the drain D of the FET Q₁ in this embodiment is not connected to the rear surface electrode 4 via such as a bias circuit, the drain D of a normally-on type transistor which is a GaAs FET usually used for a microwave is connected to the source S through the operating layer 3, which means the drain D is grounded at the rear surface electrode 4 through the source S so that the drain D does not have a high voltage due to electrification, either.

Electrostatic breakdown of the gate due to electrification in the fabrication process can be prevented because the gate G, the source S, and the drain D of the FET Q₁ are grounded at the rear surface electrode directly or via the resistor.

While in the above illustrated embodiment the source is grounded at the rear surface electrode through a second transmission line, not a source but a drain can be grounded. Furthermore, either the source or drain electrode can be grounded directly to the rear surface electrode not through the transmission line but through a via-hole which is produced directly below the source or the drain represented by broken lines in figure 2.

In the above illustrated embodiment, the gate G and the capacitor C₁ are connected by a first transmission line and the source S and the rear surface electrode 4 are connected by a second transmission line, respectively, but they can be connected by a first and a second resistors R₁ and R₂, respectively as explained in the prior art.

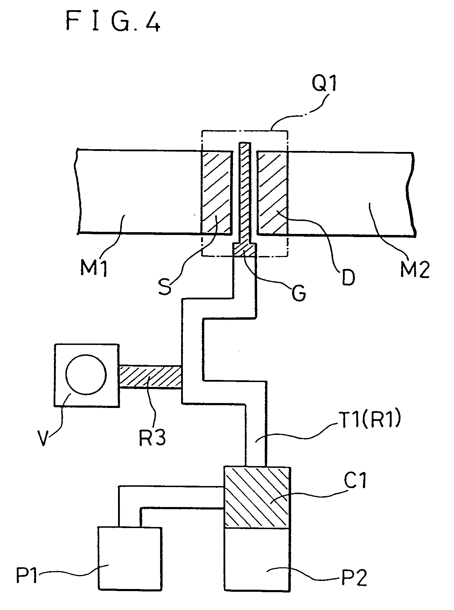

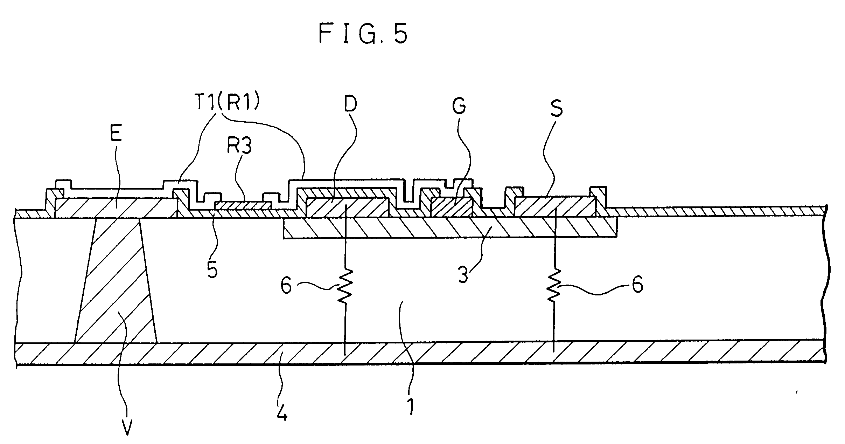

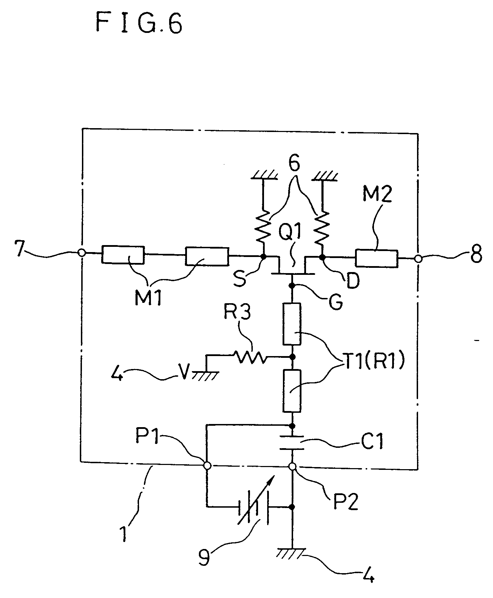

Figure 4 to figure 6 show a second embodiment of the present invention. This second embodiment is a semiconductor integrated circuit constituting a high frequency switch using a semi-insulating semiconductor substrate. Figure 4 to figure 6 are a plan view, a cross sectional view, and an equivalent circuit diagram corresponding to figure 1 to figure 3, respectively. A semi-insulating semiconductor substrate 14 is used in place of the insulating dielectric substrate in the semiconductor integrated circuit of the first embodiment and the source S and the drain D of the FET Q₁ are connected to the rear surface electrode via the substrate resistor 6. Further, since the bias circuit of the source S is provided at the outside, a second transmission line T₂ and a via-hole V for connecting the source S to the rear surface electrode are not used.

The function and effect of this embodiment will be described.

Similarly as in the first embodiment, the gate G of the FET Q₁ is grounded at the rear surface electrode 4 through the third resistor R₃, therefore, the charges conveyed by such as pure water used for washing in the semiconductor fabrication process flow into the rear surface electrode through the third resistor so that the gate G does not have a high voltage due to electrification.

Although the source S of the FET Q₁ is not connected to the rear surface electrode 4 through the via-hole V differently from first embodiment, the semi-insulating semiconductor substrate 1 is used as a dielectric substrate and the source S and the drain D are grounded at the rear surface electrode 4 via the substrate resistor 6; therefore neither the source S nor the drain D has a high voltage due to electrification.

Electrostatic breakdown of the gate caused by the electrification in the fabrication process can be prevented because the gate G, the source S, and the drain D of the FET Q₁ are grounded at the rear surface electrode directly or via the resistor.

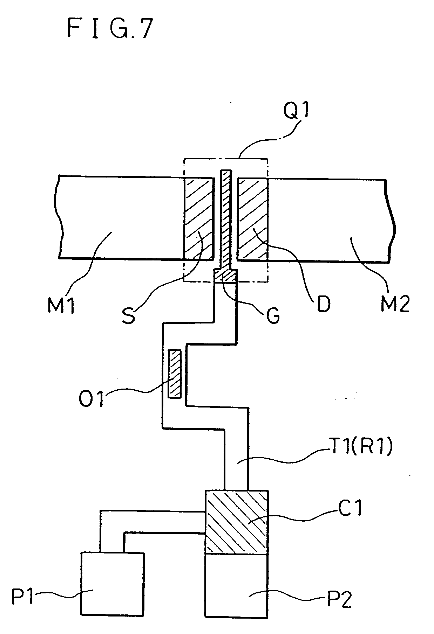

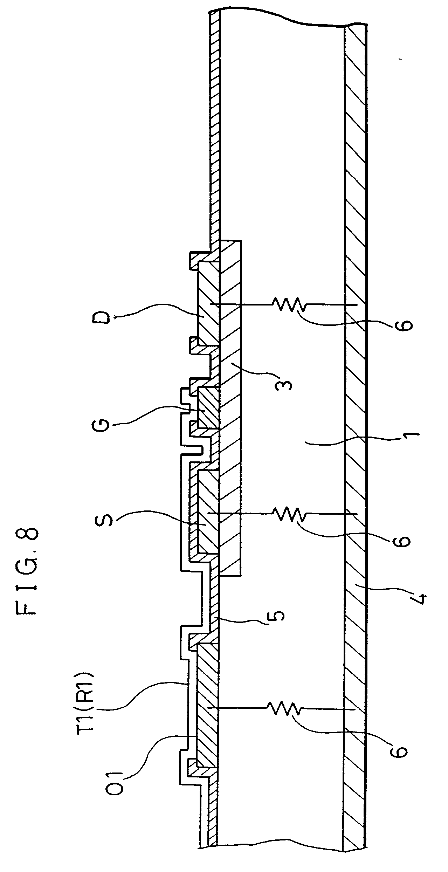

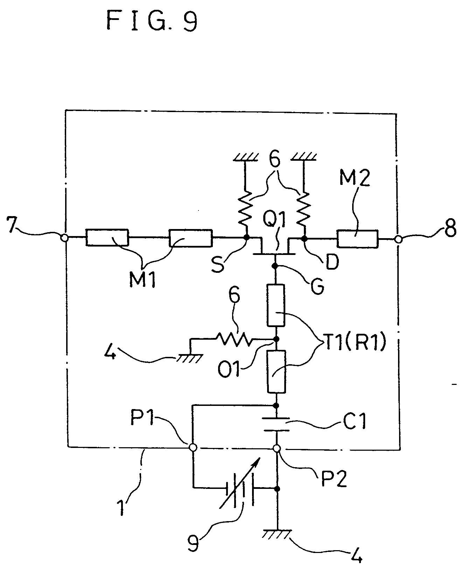

Figure 7 to figure 9 show a plan view, a cross sectional view, and an equivalent circuit diagram of a semiconductor integrated circuit in accordance with a third embodiment of the present invention, which correspond to figure 4 to figure 6, respectively. In this third embodiment, an ohmic electrode O₁ is produced below a portion of the first transmission line T₁ in the construction of the second embodiment, and thus the gate G and the rear surface electrode 4 are connected with each other. In this case, the ohmic electrode O₁ has sufficiently large area so that the electric resistance between the gate G and the rear surface electrode 4 becomes as small as that of the substrate resistor 6. The other construction is the same as those of the second embodiment.

The function and effect of this embodiment will be described.

In this embodiment, differently from the first embodiment, the source S of the FET Q₁ is not connected to the rear surface electrode 4 through the via-hole V. However, similarly as in the second embodiment, since the semi-insulating semiconductor substrate 1 is used as a substrate, the source S and the drain D are connected to the rear surface electrode 4 via the substrate resistor 6 and neither of them has a high voltage due to electrification.

Furthermore, since a portion of the first transmission line T₁ is in contact with the semi-insulating semiconductor substrate 1 using the ohmic electrode O₁, the gate G of the FET Q₁ is grounded at the rear surface electrode 4 via the substrate resistor 6 and the gate G does not have a high voltage due to electrification.

In this way, the gate G, the source S and the drain D of the FET Q₁ are grounded at the rear surface electrode directly or via the resistor, electrostatic breakdown of-the gate due to electrification can be prevented.

While a high frequency switch circuit is shown as an example of a semiconductor integrated circuit in the above illustrated embodiment, an amplifier, an oscillator, a phase-shifter, or an attenuator can be adopted in place of a switch, and a microwave semiconductor integrated circuit having a gate bias circuit similar to the above illustrated embodiment can be used with the same effects.

In the above illustrated first and second embodiment, a third resistor comprising a refractory metal silicide is produced on the insulting film on the substrate, but in a case where a semi-insulating semiconductor substrate is used as shown in the second embodiment, the third resistor can be produced by an ion implantation at a surface portion of the substrate.

As is evident from the foregoing description, according to the present invention, a gate bias circuit of a field effect transistor is connected to the rear surface electrode via a high resistance auxiliary current path. Therefore, static electricity charged to the gate bias bonding pad and the capacitor constituting the gate bias circuit flows through an auxiliary current path and almost no static electricity flows to the gate of the FET, so that the electrostatic breakdown of the gate in the semiconductor fabrication process can be prevented. The auxiliary current path is constructed of an electrode wiring which is in ohmic contact with the semi-insulating semiconductor substrate, and thus the substrate resistance of a semi-insulating semiconductor substrate functions similarly as the above described auxiliary current path. Therefore, the via-hole or a wiring for connecting a gate with a rear surface electrode can be dispensed with, thereby the construction is simplified.

## Claims

1. A microwave monolithic integrated circuit comprising:
a substrate (1) either of dielectric insulative material or of semiconductor semi-insulative material;
a ground plane electrode (4) provided at a rear surface of said substrate (1);
a field effect transistor including source, gate, and drain electrodes (S,G,D), provided at a front surface of said substrate (1);
a gate bias bonding pad (P1), provided at said front surface of said substrate (1) at a distance from said gate electrode (G), for applying a bias potential to said gate electrode (G); and
a first conductive path (T1(R1)), extending between and connecting, said gate bias bonding pad (P1) and said gate electrode (G), and which is impedance matched to said gate electrode (G);
which microwave monolithic integrated circuit is characterised by:
a second conductive path (R3 & V; 01 & 6), specifically a high resistance d.c. shunt path, which extends from a region of said first conductive path (T1(R1)) to said ground plane electrode (4), the resistance (R3;6) of which second conductive path (R3 & V; 01 & 6) is so high that impedance loading at a.c. is negligible and microwave operation is substantially unaltered while nonetheless an effective and alternative discharge path is provided for electrostatic charge which otherwise would accumulate at said gate electrode (G) and/or said gate bias bonding pad (P1) during manufacture.

2. A microwave monolithic integrated circuit (e.g. figs. 1-3) as claimed in claim 1 wherein:
said substrate (1) is of dielectric material;
said field effect transistor (S,G,D) is provided in and upon a layer (2) of semiconductor material located on said substrate front surface;
one of said source and drain electrodes (S,D) is connected to said ground plane electrode (4) by a first via-conductor (V) extending from said layer (2) through said substrate (1); and
said second conductive path (R3 & V) includes a second via-conductor (V) also extending from said layer (2) through said substrate (1).

3. A microwave monolithic integrated circuit (e.g. figs. 4-6) as claimed in claim 1 wherein:
said substrate (1) is of semiconductor semi-insulative material;
said field effect transistor (S,G,D) is provided in and upon an active layer (3) defined in a front surface region of said substrate (1); and
said second conductive path (R3 & V) includes a via-conductor (V) extending from the front surface to the rear surface of said substrate (1).

4. A microwave monolithic integrated circuit (e.g. figs. 7-9) as claimed in claim 1 wherein:
said substrate (1) is of semiconductor semi-insulative material;
said field effect transistor (S,G,D) is provided in and upon an active layer (3) defined in a front surface region of said substrate; and
said second conductive path (01 & 6) includes an ohmic contact (01) connecting said first conductive path (T1(R1)) and said substrate (1) and a resistive path (6) through said substrate (1) connecting said ohmic contact (01) and said ground plane electrode.

5. A microwave monolithic integrated circuit as claimed in either of claims 2 or 3, respectively, wherein said second conductive path (R3 & V) includes a resistor (R3) of refractory metal silicide providing electrical connection between said first conductive path (T1(R1)) and said second via-conductor (V) or said via-conductor (V), respectively.

6. A microwave monolithic integrated circuit as claimed in claim 3 wherein said second conductive path (R3 & V) includes a resistor (R3) comprised of an ion implanted surface region of said substrate (1).

7. A microwave monolithic integrated circuit as claimed in claim 4 wherein said ohmic contact (01) is of such an area that electrical resistance between said gate electrode (G) and said ground plane electrode (4) is as small as substrate resistance (6) between each of said source and drain electrodes (S,D) and said ground plane electrode (4).

8. A microwave monolithic integrated circuit as claimed in claim 2 wherein said first via-conductor (V) is located directly below said one of said source and drain electrodes (S,D).

9. A microwave monolithic integrated circuit as claimed in any preceding claim wherein a capacitor (C1) is provided connecting said first conductive path (T1(R1)) to an additional bonding pad (P2).

10. A microwave monolithic integrated circuit as claimed in any preceding claim wherein said first conductive path (T1(R1)) comprises a transmission line or a resistor.

11. A microwave monolithic integrated circuit as claimed in any preceding claim wherein said field effect transistor (S,G,D) is operated and used as a high-frequency switch element.

## Patentansprüche

1. Monolithische integrierte Mikrowellenschaltung mit:
einem Substrat (1), das entweder aus einem dielektrischen isolierenden Material oder aus einem halbleitenden halbisolierenden Material besteht;
einer Masse-Flächenelektrode (4), die an einer rückseitigen Oberfläche des Substrats (1) vorgesehen ist;
einem Feldeffekttransistor, der Source-, Gate- und Drainelekroden (S,G,D) beinhaltet, die an einer vorderseitigen Oberfläche des Substrats (1) vorgesehen sind;
einer Gatevorspannungs-Verbindungsanschlußfläche (P1), die an der vorderseitigen Oberfläche des Substrats (1) in einem Abstand von der Gateelektrode (G) vorgesehen ist und ein Vorspannungspotential an die Gateelektrode (G) anlegt; und
einem ersten leitenden Pfad (T1(R1)), der sich zwischen der Gatevorspannungs-Verbindungsanschlußfläche (P1) und der Gateelektrode (G) erstreckt und diese verbindet, und welcher an die Gateelektrode (G) impedanzangepaßt ist;
wobei die monolithische integrierte Mikrowellenschaltung gekennzeichnet ist durch:
einen zweiten leitenden Pfad (R3 & V; 01 & 6), genauer gesagt einen Gleichstrom-Kurzschlußpfad mit einem hohen Widerstand, welcher sich aus einem Bereich des ersten leitenden Pfads (T1(R1)) zu der Masse-Flächenelektrode (4) erstreckt, wobei der Widerstand (R3;6) des zweiten leitenden Pfads (R3 & V; 01 & 6) so hoch ist, daß eine Impedanzbelastung bei Wechselstrom unbedeutend ist und ein Mikrowellenbetrieb im wesentlichen unverändert ist, während nichtsdestoweniger ein wirkungsvoller und alternativer Entladungspfad für eine elektrostatische Ladung geliefert wird, welche ansonsten während der Herstellung an der Gateelektrode (G) und/oder der Gatevorspannungs-Verbindungsanschlußfläche (P1) gespeichert werden würde.

2. Monolithische integrierte Mikrowellenschaltung (z.B. Figuren 1-3) nach Anspruch 1, bei der:
das Substrat (1) aus einem dielektrischen Material besteht;
der Feldeffekttransistor (S,G,D,) in und auf einer Schicht (2) eines Halbleitermaterials vorgesehen ist, das sich auf der vorderseitigen Oberfläche des Substrats befindet;
eine der Source- und Drainelektroden (S,D) durch einen ersten Durchgangsleiter (V), der sich von der Schicht (2) durch das Substrat (1) erstreckt, an die Masse-Flächenelektrode (4) angeschlossen ist; und
der zweite leitende Pfad (R3 & V) einen zweiten Durchgangsleiter (V) beinhaltet, der sich ebenso von der Schicht (2) durch das Substrat (1) erstreckt.

3. Monolithische integrierte Mikrowellenschaltung (z.B. Figuren 4-6) nach Anspruch 1 bei der:
das Substrat (1) aus einem halbleitenden halbisolierenden Material besteht;
der Feldeffekttransistor (S,G,D) in und auf einer aktiven Schicht (3) vorgesehen ist, die auf einem vorderseitigen Oberflächenbereich des Substrats (1) definiert ist; und
der zweite leitende Pfad (R3 & V) einen Durchgangsleiter (V) beinhaltet, der sich von der vorderseitigen Oberfläche zu der rückseitigen Oberfläche des Substrats (1) erstreckt.

4. Monolithische integrierte Mikrowellenschaltung (z.B. Figuren 7-9) nach Anspruch 1, bei der:
das Substrat (1) aus einem halbleitenden halbisolierenden Material besteht;
der Feldeffekttransistor (S,G,D) in und auf einer aktiven Schicht (3) vorgesehen ist, die in einem vorderseitigen Oberflächenbereich des Substrats definiert ist;
der zweite leitende Pfad (01 & 6) einen ohmschen Kontakt (01), der den ersten leitenden Pfad (T1(R1)) und das Substrat (1) verbindet und einen mit Widerstand behafteten Pfad (6) durch das Substrat (1) beinhaltet, der den ohmschen Kontakt (01) und die Masse-Flächenelektrode verbindet.

5. Monolithische integrierte Mikrowellenschaltung nach Anspruch 2 oder 3, bei der der zweite leitende Pfad (R3 & V) einen Widerstand (R3) aus einer schwer schmelzenden Metall-Siliziumverbindung beinhaltet, der eine elektrische Verbindung zwischen dem ersten leitenden Pfad (T1(R1)) und dem zweiten Durchgangsleiter (V) bzw. dem Durchgangsleiter (V) liefert.

6. Monolithische integrierte Mikrowellenschaltung nach Anspruch 3, bei der der zweite leitende Pfad (R3 & V) einen Widerstand (R3) beinhaltet, der aus einem ionenimplantierten Oberflächenbereich des Substrats (1) zusammengesetzt ist.

7. Monolithische integrierte Mikrowellenschaltung nach Anspruch 4, bei der der ohmsche Kontakt (01) aus einer solchen Fläche besteht, daß der elektrische Widerstand zwischen der Gateelektrode (G) und der Masse-Flächenelektrode (4) so klein ist, wie der Substratwiderstand (6) zwischen jeder der Source- und Drainelektroden (S,D) und der Masse-Flächenelektrode (4).

8. Monolithische integrierte Mikrowellenschaltung nach Anspruch 2, bei der sich der erste Durchgangsleiter (V) direkt unterhalb der einen der Source- und Drainelektroden (S,D) befindet.

9. Monolithische integrierte Mikrowellenschaltung nach einem der vorhergehenden Ansprüche, bei der ein Kondensator (C1) vorgesehen ist, der den ersten leitenden Pfad (T1(R1)) an eine zusätzliche Verbindungsanschlußfläche (P2) anschließt.

10. Monolithische integrierte Mikrowellenschaltung nach einem der vorhergehenden Ansprüche, bei der der erste leitende Pfad (T1(R1)) eine Übertragungsleitung oder einen Widerstand aufweist.

11. Monolithische integrierte Mikrowellenschaltung nach einem der vorhergehenden Ansprüche, bei der der Feldeffekttransistor (S,G,D) als ein Hochfrequenz-Schaltelement betrieben und verwendet wird.

## Revendications

1. Circuit intégré monolithique à onde ultracourte, comprenant :
un substrat (1) soit en matériau isolant diélectrique soit en matériau semi-isolant semi-conducteur;
une électrode de plan de masse (4) prévue à une surface arrière dudit substrat (1);
un transistor à effet de champ comprenant des électrodes de source, de porte et de drain (S,G,D), prévu à une surface avant dudit substrat (1);
un point de liaison de polarisation de porte (P1), prévu à ladite surface avant dudit substrat (1), à une distance de l'électrode de porte (G), pour appliquer un potentiel de polarisation à l'électrode de porte (G); et
un premier trajet conducteur (T1(R1), s'étendant entre et reliant ledit point de liaison de polarisation de porte (P1) et ladite électrode de porte (G), et qui est en accord d'impédance avec l'électrode de porte (G);
lequel circuit intégré monolithique à onde ultra-courte est caractérisé par :
un second trajet conducteur (R3 & V; 01 & 6), spécifiquement un trajet de shunt à courant continu de résistance élevée, qui s'étend d'une région dudit premier trajet conducteur (T1(R1) à ladite électrode de plan de masse (4), la résistance (R3;6) duquel second trajet conducteur (R3 & V; 01 & 6) est si élevée que la charge d'impédance en alternatif est négligeable et le fonctionnement à onde ultra-courte n'est sensiblement pas altéré bien que, néanmoins, un trajet de décharge effectif et alternatif soit prévu pour la charge électrostatique qui autrement s'accumulerait à l'électrode de porte (G) et/ou au point de liaison de polarisation de porte (P1)pendant la fabrication.

2. Circuit intégré monolithique à onde ultra-courte (par exemple figs. 1-3) comme revendiqué en revendication 1, dans lequel :
le substrat précité (1) est en matériau diélectrique;
le transistor à effet de champ précité (S,G,D) est prévu dans et sur une couche (2) de matériau semi-conducteur situé sur la surface avant du substrat précité;
l'électrode de source ou l'électrode de drain (S,D) est reliée à l'électrode de plan de masse précitée (4) par un premier conducteur traversant (V) et s'étendant de ladite couche (2) à travers ledit substrat (1); et
le second trajet conducteur précité (R3 & V) comprend un second conducteur traversant (V) s'étendant également de ladite couche (2) à travers ledit substrat (1).

3. Circuit intégré monolithique à onde ultra-courte (par exemple figs. 4-6) comme revendiqué en revendication 1, dans lequel :
le substrat précité (1) est en matériau semi-isolant semi-conducteur;
le transistor à effet de champ précité (S,G,D) est prévu dans et sur une couche active (3) définie dans une région de surface avant dudit substrat (1); et
le second trajet conducteur précité (R3 & V) comprend un conducteur traversant (V) s'étendant de la surface avant à la surface arrière dudit substrat (1).

4. Circuit intégré monolithique à onde ultra-courte (par exemple figs. 7-9) comme revendiqué en revendication 1, dans lequel :
le substrat précité (1) est en matériau semi-isolant semi-conducteur;
le transistor à effet de champ précité (S,G,D) est prévu dans et sur une couche active (3) définie dans une région de surface avant dudit substrat; et
le second trajet conducteur précité (01 & 6) comprend un contact ohmique (01) reliant le premier trajet conducteur précité (T1(R1) et ledit substrat (1) et un trajet résistif (6) à travers ledit substrat (1) reliant ledit contact ohmique (01) et l'électrode de plan de masse précitée.

5. Circuit intégré monolithique à onde ultra-courte comme revendiqué dans la revendication 2 ou la revendication 3, respectivement, dans lequel le second trajet conducteur précité (R3 & V) comprend une résistance (R3) de siliciure de métal réfractaire produisant une connexion électrique entre le premier trajet conducteur précité (T1(R1) et respectivement le second conducteur traversant précité (V) ou le conducteur traversant précité (V).

6. Circuit intégré monolithique à onde ultra-courte comme revendiqué en revendication 3, dans lequel le second trajet conducteur précité (R3 & V) comprend une résistance (R3) constituée d'une région de surface implantée par ions du substrat précité (1).

7. Circuit intégré monolithique à onde ultra-courte comme revendiqué en revendication 4, dans lequel le contact ohmique précité (01) est d'une telle surface qu'une résistance électrique entre l'électrode de porte précitée (G) et l'électrode de plan de masse précitée (4) est aussi petite que la résistance de substrat (6) entre chacune des électrodes de source et de drain précitées (S,D) et ladite électrode de plan de masse (4).

8. Circuit intégré monolithique à onde ultra-courte comme revendiqué en revendication 2, dans lequel le premier conducteur traversant précité (V) est situé directement en dessous de l'une précitée des électrodes de source et de drain (S,D).

9. Circuit intégré monolithique à onde ultra-courte comme revendiqué dans l'une quelconque des revendications précédentes, dans lequel un condensateur (C1) est prévu reliant le premier trajet conducteur précité (T1(R1) à un point de liaison additionnel (P2).

10. Circuit intégré monolithique à onde ultra-courte comme revendiqué dans l'une quelconque des revendications précédentes, dans lequel le premier trajet conducteur précité (T1(R1) comprend une ligne de transmission ou une résistance.

11. Circuit intégré monolithique à onde ultra-courte comme revendiqué dans l'une quelconque des revendications précédentes, dans lequel le transistor à effet de champ précité (S,G,D) est mis en service et utilisé comme élément interrupteur haute fréquence.
